# EUROPEAN PATENT APPLICATION

(11) **EP 4 803 915 A1**
(43) Date of publication of application: **09.09.2026**
(21) Application number: 26160957.2
(22) Date of filing: 26.02.2026
(51) Int. Cl.: G01R 31/52, H01M 10/48

(54) **BATTERY SYSTEM**

(30) Priority: 07.03.2025 JP 2025036224
(71) Applicant: Prime Planet Energy & Solutions, Inc., Chuo-ku, Tokyo 103-0022 (JP)
(72) Inventor: NAKAYAMA, Masato, Tokyo, 103-0022 (JP); YANO, Junya, Tokyo, 103-0022 (JP)
(74) Representative: Kuhnen & Wacker Patent- und Rechtsanwaltsbüro PartG mbB

(57) **Abstract**

A battery system 100 disclosed here includes a battery cell 10, a temperature sensor 60, a reference power supply 80, a first detection resistor 111, a second detection resistor 112, and a short circuit detector 120. The temperature sensor 60 is attached to the battery cell 10 via an insulating member and measures the temperature of the battery cell 10. The reference power supply 80 applies a reference voltage Vref to the temperature sensor 60. The first detection resistor 111 is located between the reference power supply 80 and the temperature sensor 60. The second detection resistor 112 is located between ground (GND) of the battery cell 10 and the temperature sensor 60. The short circuit detector 120 performs a first voltage acquisition process, a second voltage acquisition process, and a short circuit detection process.

## Description

### BACKGROUND

The present disclosure relates to a battery system.

### Background Art

Japanese Patent No. 6599834 discloses a battery temperature monitoring system including a temperature measurement circuit unit and a calculation unit. The temperature measurement circuit unit includes a thermistor, a reference power supply, a common negative electrode line, and a short circuit detection resistor. The calculation unit includes a voltage detection unit and a short circuit determination unit. Japanese Patent No. 6599834 describes that the short circuit determination unit determines the presence or absence of a short circuit between a thermistor to be measured and a battery cell in contact with the thermistor, on the basis of a measured voltage.

### SUMMARY

There is a need for further developing a technique for enabling detection of a short circuit between a battery cell and a temperature sensor.

A battery system disclosed here includes a battery cell, a temperature sensor, a reference power supply, a first detection resistor, a second detection resistor, and a short circuit detector. The temperature sensor is attached to the battery cell via an insulating member and measures a temperature sensor of the battery cell. The reference power supply applies a reference voltage to the temperature sensor. The first detection resistor is located between the reference power supply and the temperature sensor. The second detection resistor is located between ground of the battery cell and the temperature sensor. The short circuit detector performs a first voltage acquisition process, a second voltage acquisition process, and a short circuit detection process. In the first voltage acquisition process, a voltage applied across the first detection resistor is acquired. In the second voltage acquisition process, a voltage applied across the second detection resistor is acquired. In the short circuit detection process, a short circuit between the battery cell and the temperature sensor is detected based on a resistance value of the first detection resistor and a resistance value of the second detection resistor, a voltage value acquired by the first voltage acquisition process, and a voltage value acquired by the second voltage acquisition process. The battery system with the configuration described above is capable of detecting a short circuit between the battery cell and the temperature sensor.

### BRIEF DESCRIPTION OF THE DRAWINGS

FIG. 1 is a cross-sectional view illustrating an example of a battery cell.
FIG. 2 is a cross-sectional view illustrating a battery cell of another example.
FIG. 3 is a schematic view of a battery system.
FIG. 4 is a schematic view for illustrating attachment of a temperature sensor to a battery case.
FIG. 5 is a schematic view illustrating an example of a short circuit between a battery cell and a temperature sensor in the battery system of FIG. 3.
FIG. 6 is a schematic view of another battery system.
FIG. 7 is a schematic view of a battery system according to one preferred embodiment.
FIG. 8 is a block diagram illustrating a configuration of a short circuit detector according to one preferred embodiment.
FIG. 9 is a flowchart for describing a configuration of a short circuit detection processor according to one preferred embodiment.
FIG. 10 is a schematic view illustrating another example of a short circuit between a battery cell and a temperature sensor in the battery system of FIG. 7.
FIG. 11 is a schematic view of a battery system according to another preferred embodiment.
FIG. 12 is a schematic view illustrating another example of a short circuit between a battery cell and a temperature sensor in the battery system of FIG. 11.

### DETAILED DESCRIPTION

Some preferred embodiments of the technique disclosed here will be described hereinafter with reference to the drawings. In the drawings, members and portions having the same functions are denoted by the same reference numerals as appropriate. Dimensional relationships (e.g., length, width, and thickness) in the drawings do not reflect actual dimensional relationships. The technique disclosed here can be carried out based on the contents disclosed herein and common general knowledge in the field. The following description is not intended to limit the present disclosure to the following embodiments. The expression "A to B" indicating a range herein means "A or more and B or less." The expression "A to B" includes the meaning of "more than A" and "less than B."

### <Battery Cell 10>

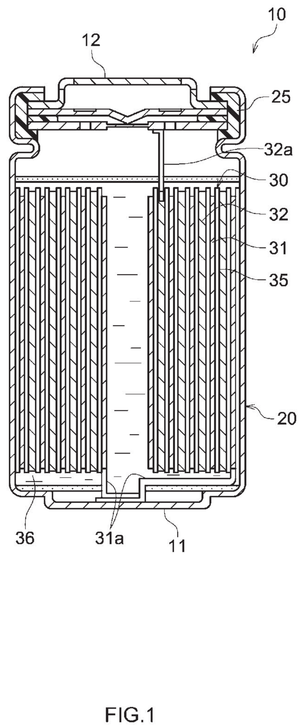

FIG. 1 is a cross-sectional view illustrating an example of a battery cell 10. In the example illustrated in FIG. 1, the battery cell 10 is a cylindrical battery. As illustrated in FIG. 1, the battery cell 10 includes a battery case 20, and electrode body 30, and an electrolyte 36.

### (Battery Case 20)

The battery case 20 is a container that houses the electrode body 30. In the example illustrated in FIG. 1, the battery case 20 has a substantially cylindrical shape with a bottom. A positive electrode terminal 11 is located at the bottom of the battery case 20. The battery case 20 is preferably made of a metal. Examples of the metal include aluminum, aluminum alloys, and stainless steel (SUS).

### (Electrode Body 30)

The electrode body 30 includes a positive electrode sheet 31 (positive electrode), a negative electrode sheet 32 (negative electrode), and a separator sheet 35 (separator).

The positive electrode sheet 31 is a member in which a positive electrode active material layer containing a positive electrode active material is located on one or each surface of metal foil (e.g., aluminum foil). As the positive electrode active material, a known material that may be used in this type of battery can be used without any particular limitation. In the example illustrated in FIG. 1, the positive electrode sheet 31 includes a positive electrode tab 31a. The positive electrode sheet 31 is connected to a radially center portion of one end of the battery case 20 via the positive electrode tab 31a. The positive electrode tab 31a is preferably made of a metal (e.g., aluminum).

The negative electrode sheet 32 is a member in which a negative electrode active material layer containing a negative electrode active material is located on one or each surface of metal foil (e.g., copper foil). As the negative electrode active material, a known material that may be used in this type of battery can be used without any particular limitation. In the example illustrated in FIG. 1, the negative electrode sheet 32 includes a negative electrode tab 32a. The negative electrode sheet 32 is connected to a radially center portion of the other end of the battery case 20 via the negative electrode tab 32a. The negative electrode tab 32a is preferably made of a metal (e.g., copper).

The separator sheet 35 is a member that insulates the positive electrode sheet 31 and the negative electrode sheet 32 from each other. The separator sheet 35 is preferably a porous resin sheet. The separator sheet 35 may include a heat-resistant layer with a required heat resistance, for example.

### (Electrolyte 36)

The electrolyte 36 herein is a liquid electrolyte (electrolytic solution). As the electrolyte 36, a known material that may be used in this type of battery can be used without any particular limitation. In the battery cell 10, charge carriers move between the positive electrode sheet 31 and the negative electrode sheet 32 via the electrolyte 36, thereby enabling repetitive charging and discharging. The battery cell 10 may be, for example, a lithium ion secondary battery in which lithium ions function as charge carriers.

In the example illustrated in FIG. 1, the positive electrode tab 31 is electrically connected to the bottom of the battery case 20 in the battery cell 10. The negative electrode tab 32a is electrically connected to the negative electrode terminal 12 in the battery cell 10. In the battery cell 10, a bottom end portion of the battery case 20 functions as the positive electrode terminal 11. The battery case 20 is electrically connected to the positive electrode sheet 31. In this manner, in the battery cell 10 illustrated in FIG. 1, the battery case 20 has the same potential as the positive electrode. The negative electrode terminal 12 is insulated from the battery case 20 by an insulator 25, and is electrically connected to the negative electrode sheet 32. Although not shown, in another preferred embodiment, the battery case 20 may have the same potential as the negative electrode. In this manner, in the example of the battery cell 10 illustrated in FIG. 1, the battery case 20 (exterior can) may use a potential that is the same as the positive electrode or the same as the negative electrode.

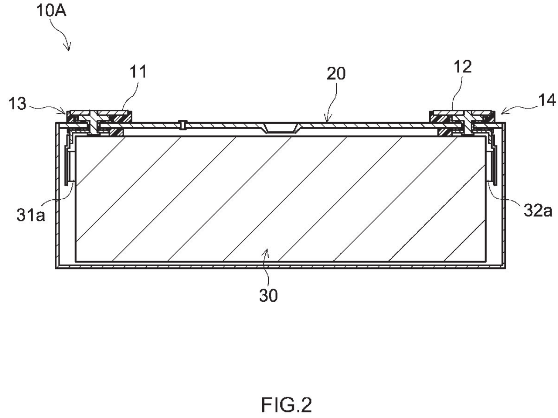

The battery cell 10 is not limited to this example. For example, FIG. 2 is a cross-sectional view illustrating a battery cell 10A according to another example. In the battery cell 10A, as illustrated in FIG. 2, the positive electrode terminal 11 and the negative electrode terminal 12 are attached to the battery case 20 while being insulated from the battery case 20 via insulators 13 and 14. The positive electrode terminal 11 is electrically connected to the positive electrode tab 31a of the electrode body 30 housed in the battery case 20. The negative electrode terminal 12 is electrically connected to the negative electrode tab 32a of the electrode body 30.

### <Battery System 300>

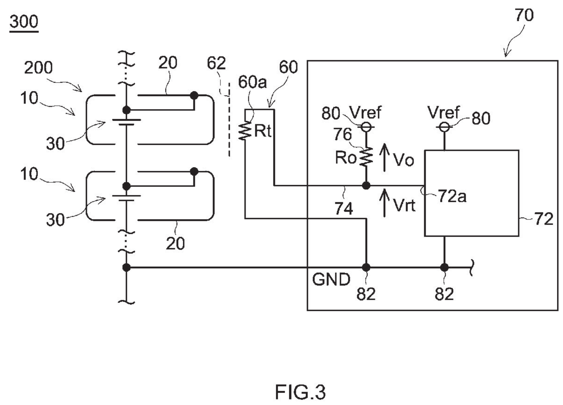

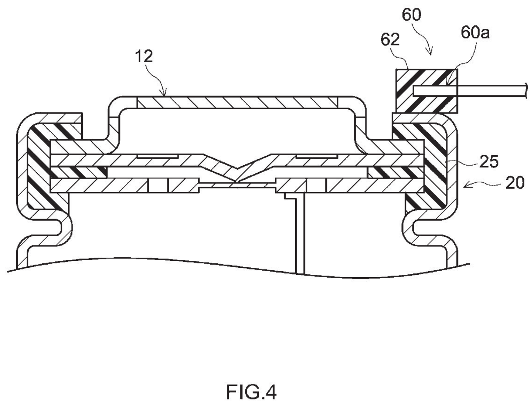

FIG. 3 is a schematic view of a battery system 300. FIG. 4 is a schematic view for illustrating attachment of a temperature sensor 60 to the battery case 20. The battery system herein refers to a system that performs various measurements and controls on a battery. Examples of the battery system include a system having the function of detecting the temperature of a battery cell. The system having the function of detecting the temperature of the battery cell may be incorporated in, for example, a system that controls a battery module 200 including a plurality of battery cells 10. The battery system 300 illustrated in FIG. 3 includes the temperature sensor 60 as a thermistor, and a temperature detector 72. The temperature detector 72 may be configured as a part of a battery control circuit 70 that controls the battery cells 10. The battery control circuit 70 measures the temperature of the battery cells 10 as well as the voltage and current of the battery cells 10, and may be used for state measurement and abnormality detection of the battery cells 10. A temperature measurement target is the battery cells 10 included in the battery module 200. In this example, the battery cells 10 are connected to the battery module 200 in series. In the example illustrated in FIG. 3, each battery cell 10 is the battery cell 10 in which the battery case 20 (exterior can) has the same potential as the positive electrode (see FIG. 1).

### (Temperature Sensor 60)

The temperature sensor 60 is a sensor that measures the temperature of the battery cells 10. As schematically illustrated in FIG. 4, a resistor 60a serving as the temperature sensor 60 is attached to the battery cell 10 via an insulating member 62. As the temperature sensor 60, a contact-type temperature sensor may be suitably used. The temperature sensor 60 includes the resistor 60a having a temperature resistance characteristic in which the resistance value varies in accordance with a change in temperature. Examples of the resistor 60a having the temperature resistance characteristic include a negative temperature coefficient (NTC) thermistor in which the resistance value decreases as the temperature rises, and a positive temperature coefficient (PTC) thermistor in which the resistance value increases as the temperature rises. In this preferred embodiment, the NTC thermistor is used as the thermistor. The shape and configuration of the thermistor are not specifically limited. As the thermistor, a commercially available thermistor can be used without any particular limitation, for example.

The resistor 60a as the temperature sensor 60 is covered with the insulating member 62 and attached to the battery cell 10 via the insulating member 62. The insulating member 62 may be made of, for example, a resin. The temperature sensor 60 is located in the battery case 20 of the battery cell 10. The temperature sensor 60 may be attached to the battery case 20 of the battery cell 10 with an adhesive, for example. The temperature sensor 60 may be attached to the battery case 20 of the battery cell 10 via a plate material with high thermal conductivity such as aluminum.

The temperature detector 72 is a device that detects the temperature of the battery cells 10 based on a resistance value (Rt) of the temperature sensor 60. In the example illustrated in FIG. 3, the temperature detector 72 is constituted by an AD convertor. The AD convertor as the temperature detector 72 is connected to a reference power supply 80 and connected to a reference voltage (Vref) and a ground potential 82.

### (Reference Power Supply 80)

The reference power supply 80 herein is a power supply that drives the battery system 300. In this example, the power supply 80 applies the reference voltage (Vref) serving as a reference of the battery system 300. The reference power supply 80 is constituted by a circuit that outputs the reference voltage (Vref) serving as a reference of the battery system 300. Ground (GND) is a so-called potential that serves as a reference of a voltage in a circuit. In an onboard battery of an electric vehicle, the ground corresponds to a total negative potential.

The temperature detector 72 includes an inputter 72a that acquires a resistance value of the temperature sensor 60. The inputter 72a is connected to the ground potential 82 via the temperature sensor 60. A detection line 74 connected to the inputter 72a from the temperature sensor 60 is connected to the reference power supply 80 via a reference resistor 76. In the configuration described above, the thermistor is an electronic component that detects a change in temperature as a change in resistance value, and thus, the voltage is divided in combination with the reference resistor 76, thereby obtaining an output voltage depending on the change in temperature. As the reference resistor 76, a resistor having a suitable resistance value in accordance with a temperature range to be measured by the temperature sensor 60 is preferably employed. The temperature detected by the temperature sensor 60 herein is obtained based on a detected voltage (Vrt) that is obtained by dividing a potential (reference voltage) of the reference power supply 80 in accordance with the reference resistor 76 (R0) and the resistance (Rt) of the temperature sensor 60.

The temperature sensor 60 is attached to the battery case 20 of the battery cell 10 while being electrically insulated from the battery case 20 as described above. However, a short circuit might occur between the temperature sensor 60 and the outer surface of the battery case 20 because of some cause (e.g., individual defects, manufacturing defects, vibrations during use, shocks, aged deterioration, etc.). Examples of a possible short circuit between the temperature sensor 60 and the battery case 20 include a short circuit occurring in wiring on the side of the ground (GND) of the temperature sensor 60 or in wiring on the side of the temperature detector 72 of the temperature sensor 60.

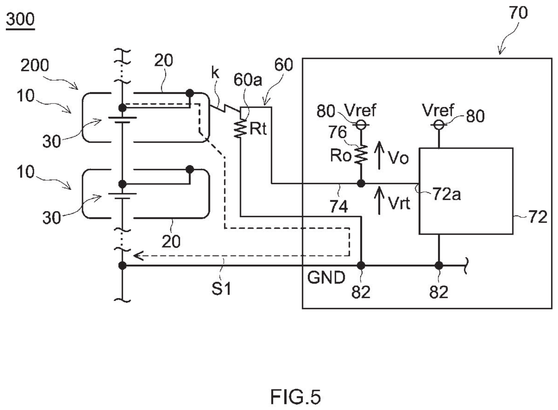

FIG. 5 is a schematic view illustrating an example of a short circuit between the battery cell 10 and the temperature sensor 60 in the battery system 300 of FIG. 3. FIG. 5 shows a case where in the battery system 300 illustrated in FIG. 3, a short circuit (k) occurs between the temperature sensor 60 and the battery case 20 to cause an abnormal leakage current (see broken arrow S1) in the circuit of the temperature sensor 60. In the case where the abnormal leakage current (see broken arrow S1) is caused in the circuit of the temperature sensor 60 by the short circuit (k) between the temperature sensor 60 and the battery case 20, voltage values V0 and Vrt measured in the temperature detector 72 vary, as illustrated in FIG. 5. Alternatively, it cannot be determined whether the variation in Vrt was caused by a change in the resistance of the temperature sensor or by the short circuit. Thus, the temperature detector 72 cannot detect a short circuit. It is considered that the event in which the short circuit cannot be detected may occur in the same manner in a case where a short circuit occurs in wiring on the side of the ground (GND) of the temperature sensor 60 and in a case where a short circuit occurs in wiring on the side of the temperature detector 72 of the temperature sensor 60.

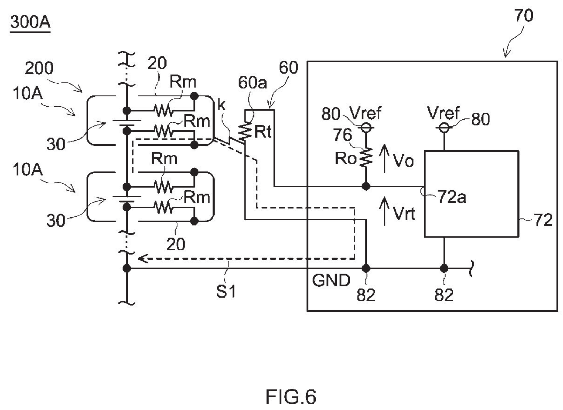

FIG. 6 is a schematic view of another system 300A. The system 300A of FIG. 6 employs a battery cell 10A (see FIG. 2) in which the battery case 20 (exterior can) is insulated from the electrode body 30 and the electrode terminals. In this case, the battery case 20 may be electrically connected to the electrode body 30 via an electrolytic solution in the battery cell 10A inevitably with a resistance Rm of about several tens of kΩ. Therefore, an abnormal leakage current (see broken arrow S1) may flow in the circuit of the temperature sensor 60. In this case, voltage values V0 and Vrt may also vary, as illustrated in FIG. 5. However, similarly to the case in FIG. 5, it cannot be determined whether the variation in Vrt was caused by a change in the resistance of the temperature sensor or by the short circuit. Thus, the temperature detector 72 cannot detect the short circuit.

In a system that controls a battery module including a plurality of battery cells, it is desirable that the temperature of the battery cells is appropriately measured and managed. In a case where a short circuit occurs between the temperature sensor 60 and the battery case 20, the short circuit is preferably detected early.

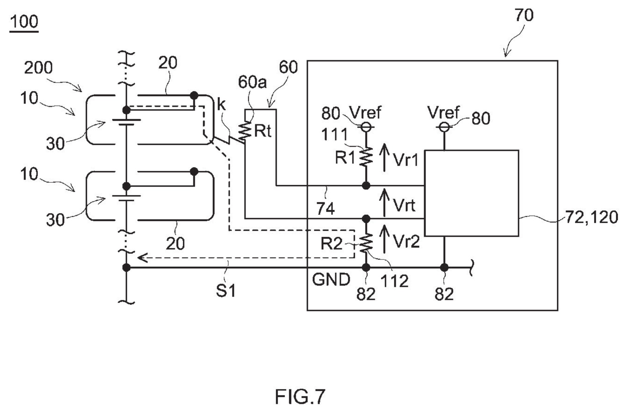

FIG. 7 is a schematic view of a battery system 100 according to one preferred embodiment.

### <Battery System 100>

As illustrated in FIG. 7, the battery system 100 includes the battery cells 10, the temperature sensor 60, the reference power supply 80, a first detection resistor 111, a second detection resistor 112, and a short circuit detector 120. The short circuit detector 120 herein detects a short circuit based on a resistance value detected by the temperature detector 72.

### (First Detection Resistor 111, Second Detection Resistor 112)

As illustrated in FIG. 7, in this preferred embodiment, the first detection resistor 111 is a resistor located between the reference power supply 80 and the temperature sensor 60. The first detection resistor 111 is located between the reference power supply 80 and the temperature sensor 60 on the battery control circuit 70. The second detection resistor 112 is a resistor located between the ground (GND) of the battery cell 10 and the temperature sensor 60. The second detection resistor 112 is located between the ground (GND) and the temperature sensor 60 on the battery control circuit 70. In this preferred embodiment, the first detection resistor 111 and the second detection resistor 112 are connected to lines of the temperature sensor 60 (thermistor in this example). In FIG. 7, resistance values R1 and R2 indicate resistance values of the first detection resistor 111 and the second detection resistor 112, respectively. Voltage values Vr1 and Vr2 indicate voltage values of the first detection resistor 111 and the second detection resistor 112, respectively. As the first detection resistor 111 and the second detection resistor 112, resistors that may be used in this type can be used without any particular limitation.

### (Short Circuit Detector 120)

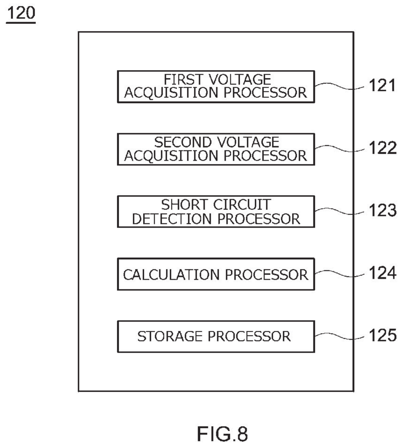

The short circuit detector 120 is a device that detects a short circuit between the battery cell 10 and the temperature sensor 60. FIG. 8 is a block diagram illustrating a configuration of the short circuit detector 120 according to one preferred embodiment. As illustrated in FIG. 8, in this preferred embodiment, the short circuit detector 120 may include a first voltage acquisition processor 121, a second voltage acquisition processor 122, and a short circuit detection processor 123. The first voltage acquisition processor 121 herein acquires the voltage value Vr1 applied across the first detection resistor 111. The second voltage acquisition processor 122 acquires the voltage value Vr2 applied across the second detection resistor 112. The short circuit detection processor 123 detects a short circuit between the battery cell 10 and the temperature sensor 60 based on the resistance value R1 of the first detection resistor 111, the resistance value R2 of the second detection resistor 112, the voltage value Vr1 acquired by the first voltage acquisition processor 121, and the voltage value Vr2 acquired by the second voltage acquisition processor 122.

In the example illustrated in FIG. 8, the short circuit detector 120 further includes a calculation processor 124 and a storage processor 125. The calculation processor 124 herein calculates a ratio of the voltage value Vr1 to the voltage value Vr2 (Vr1/Vr2). The storage processor 125 stores the ratio of the resistance value R1 to the resistance value R2 (R1/R2). The resistance value R1 and the resistance value R2 are fixed resistors mounted on an electric circuit board, and thus, may have constant values. That is, the ratio (R1/R2) may be a fixed value.

For example, in the case where the short circuit detector 120 includes the calculation processor 124 and the storage processor 125 as described above, the short circuit detection processor 123 can detect a short circuit between the battery cell 10 and the temperature sensor 60 in the following manner.

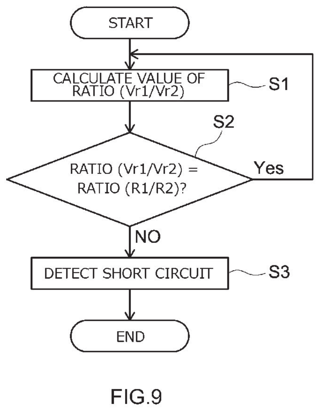

FIG. 9 is a flowchart for describing a configuration of the short circuit detection processor 123 according to one preferred embodiment. As shown in FIG. 9, first, the calculation processor 124 calculates the ratio (Vr1/Vr2) (step S1). Next, the determination processor determines whether the value of the ratio (Vr1/Vr2) is equal to the value of the ratio (R1/R2) or not (step S2). Then, if the value of the ratio (Vr1/Vr2) is equal to the value of the ratio (R1/R2) (i.e., "YES"), the short circuit detection processor 123 detects that no short circuit has occurred between the battery cell 10 and the temperature sensor 60. On the other hand, if the value of the ratio (Vr1/Vr2) is different from the value of the ratio (R1/R2) (i.e., "NO"), the short circuit detection processor 123 detects that a short circuit has occurred between the battery cell 10 and the temperature sensor 60 (step S3). If no short circuit is detected by the short circuit detection processor 123, the process returns to step S1. In this manner, the short circuit detection processor 123 can detect a short circuit between the battery cell 10 and the temperature sensor 60.

For example, as described above, in the example shown in FIG. 7, the short circuit (k) occurs on the side of the ground (GND) of the temperature sensor 60. In this case, the voltage value Vr2 increases due to the abnormal leakage current (see broken arrow S1). The voltage value Vr1 decreases as the potential of the temperature sensor 60 rises. Accordingly, the value of the ratio (Vr1/Vr2) changes. In a case where no short circuit has occurred between the battery cell 10 and the temperature sensor 60, the value of the ratio (Vr1/Vr2) is equal to the value of the ratio (R1/R2). On the other hand, in a case where a short circuit has occurred between the battery cell 10 and the temperature sensor 60, these values are different. Thus, by comparing the value of the ratio (Vr1/Vr2) with the value of the ratio (R1/R2), it is possible to detect whether a short circuit has occurred between the battery cell 10 and the temperature sensor 60 or not.

As described above, the battery system 100 according to this preferred embodiment includes the battery cells 10, the temperature sensor 60, the reference power supply 80, the first detection resistor 111, the second detection resistor 112, and the short circuit detector 120. The short circuit detector 120 includes the first voltage acquisition processor 121, the second voltage acquisition processor 122, and the short circuit detection processor 123. The short circuit detection processor 123 detects a short circuit between the battery cell 10 and the temperature sensor 60 based on the resistance value R1 of the first detection resistor 111, the resistance value R2 of the second detection resistor 112, the voltage value Vr1 acquired by the first voltage acquisition processor 121, and the voltage value Vr2 measured by the second voltage acquisition processor 122.

As illustrated in FIG. 7, in the battery system 100, a detection resistor of the temperature sensor 60 is inserted into both the side of the reference power supply 80 and the side of the ground (GND). That is, in the battery control circuit 70, the voltage value is measured at two points. As described above, in this configuration, when a short circuit occurs between the battery cell 10 and the temperature sensor 60, the voltage values Vr1 and Vr2 vary. Accordingly, compared to a normal state, the relationship between the resistor values R1 and R2 and the voltage values Vr1 and Vr2 changes. Therefore, by monitoring this change, it is possible to detect whether a short circuit has occurred between the battery cell 10 and the temperature sensor 60. Since a short circuit can be detected only by adding the second detection resistor 112 to the battery control circuit 70, the configuration is simple and preferable from the viewpoint of costs.

As described above, in the battery system 100 illustrated in FIG. 7, the short circuit detector 120 further includes the calculation processor 124 and the storage processor 125. The storage processor 125 stores the ratio (R1/R2). The calculation processor 124 calculates the ratio (Vr1/Vr2). In a normal state, the value of the ratio (R1/R2) is equal to the value of the ratio (Vr1/Vr2). Based on this, the short circuit detection processor 123 detects that no short circuit has occurred between the battery cell 10 and the temperature sensor 60 if the value of the ratio (Vr1/Vr2) is equal to the value of the ratio (R1/R2). The short circuit detection processor 123 detects that a short circuit has occurred between the battery cell 10 and the temperature sensor 60 if the value of the ratio (Vr1/Vr2) is different from the value of the ratio (R1/R2). According to this method, it is possible to detect the presence or absence of a short circuit between the battery cell 10 and the temperature sensor 60 with higher accuracy.

As described above, the battery system 100 illustrated in FIG. 7 includes the battery cells 10 each including the battery case 20, the electrode body 30, and the negative electrode terminal 12. The battery case 20 houses the electrode body 30 and is electrically connected to the positive electrode sheet 31. The negative electrode terminal 12 is insulated from the battery case 20 and is electrically connected to the negative electrode sheet 32. That is, in this preferred embodiment, the battery case 20 has the same potential as the positive electrode sheet 31. In this manner, in the case where the battery case 20 has a potential, an overvoltage might be applied to the battery control circuit 70 by contact between the battery cell 10 and the temperature sensor 60. At this time, the battery cell 10 and the battery control circuit 70 are electrically connected to each other with a high resistance value (e.g., 50 kΩ or more). As a result, the temperature sensor 60 and wiring connected to the temperature sensor 60 might be burned, causing a risk of malfunction of the battery control circuit 70.

On the other hand, in the battery system 100 illustrated in FIG. 7, the second detection resistor 112 is introduced on the side of the ground (GND) of the temperature sensor 60. Accordingly, the current value is limited on both sides of the reference power supply 80 and the ground (GND). This can suitably prevent damage of the battery control circuit 70.

The battery cell 10 in which the battery case 20 has a potential is suitable as a target of application of the technique disclosed here from the viewpoint that the issues described above are likely to occur.

The preferred embodiment of the technique disclosed here has been described above. However, the description above is merely illustrative and is not intended to limit the scope of claims. The techniques described in claims include various modifications and changes of the specific examples exemplified in the description above.

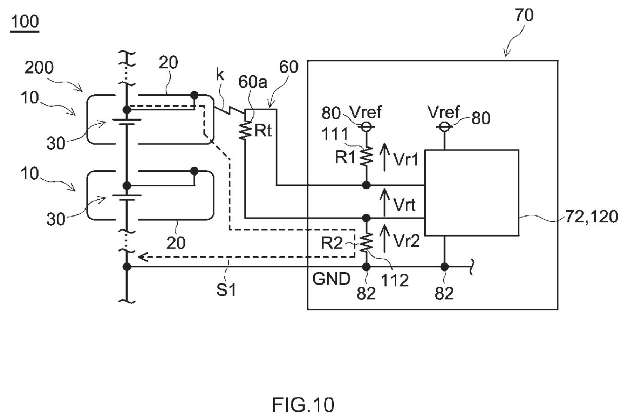

For example, FIG. 10 is a schematic view illustrating another example of a short circuit between the battery cell 10 and the temperature sensor 60 in the battery system 100 of FIG. 7. In the example illustrated in FIG. 10, a short circuit (k) occurs between the battery cell 10 and the side of the reference power supply 80 of the temperature sensor 60 as a thermistor, causing a leakage current (see broken arrow S1) to flow. In the battery system 100 illustrated in FIG. 10, the second detection resistor 112 is located between the ground (GND) of the battery cell 10 and the temperature sensor 60. Accordingly, the voltage values Vr1 and Vr2 vary, and thus, the relationship between the resistor values R1 and R2 and the voltage values Vr1 and Vr2 changes compared to a normal state. Therefore, by monitoring this change, it is possible to detect whether a short circuit has occurred between the battery cell 10 and the temperature sensor 60.

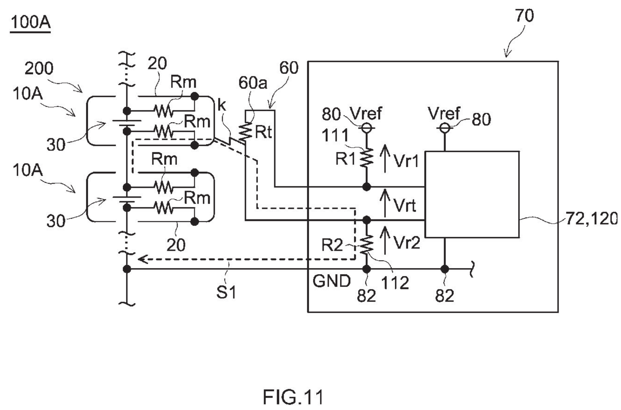

For example, FIG. 11 is a schematic view of another battery system 100A. In the example illustrated in FIG. 11, a short circuit (k) occurs between the battery cell 10A and the side of the ground (GND) of the temperature sensor 60 as a thermistor, causing an abnormal leakage current (see broken arrow S1) to flow. In the battery system 100A illustrated in FIG. 11, the second detection resistor 112 is located between the ground (GND) of the battery cell 10A and the temperature sensor 60. Accordingly, the voltage values Vr1 and Vr2 vary, and thus, the relationship between the resistor values R1 and R2 and the voltage values Vr1 and Vr2 changes compared to a normal state. Therefore, by monitoring this change, it is possible to detect whether a short circuit has occurred between the battery cell 10A and the temperature sensor 60.

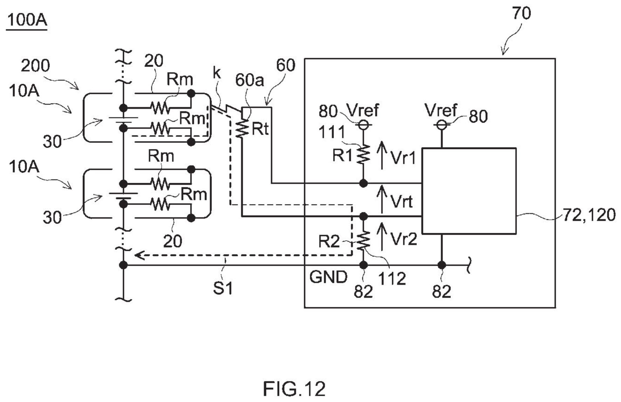

For example, FIG. 12 is a schematic view illustrating another example of a short circuit between the battery cell 10A and the temperature sensor 60 in the battery system 100A of FIG. 11. In the example illustrated in FIG. 12, a short circuit (k) occurs between the battery cell 10A and the side of the reference power supply 80 of the temperature sensor 60 as a thermistor, causing an abnormal leakage current (see broken arrow S1) to flow. In the battery system 100A illustrated in FIG. 12, the second detection resistor 112 is located between the ground (GND) of the battery cell 10A and the temperature sensor 60. Accordingly, the voltage values Vr1 and Vr2 vary, and thus, the relationship between the resistor values R1 and R2 and the voltage values Vr1 and Vr2 changes compared to a normal state. Therefore, by monitoring this change, it is possible to detect whether a short circuit has occurred between the battery cell 10A and the temperature sensor 60.

For example, in the preferred embodiment described above, the battery cell 10 is a lithium ion secondary battery, but is not limited to this example. In another preferred embodiment, the battery cell 10 may be another type of battery, such as a nickel-metal hydride battery. In the preferred embodiment described above, a liquid electrolyte (electrolytic solution) is used as the electrolyte 36 included in the battery cell 10, but the present disclosure is not limited to this example. In another preferred embodiment, the electrolyte 36 may be gelled or a solid electrolyte. The same holds for the battery cell 10A.

For example, in the preferred embodiment described above, the shape of the battery cell 10 is cylindrical, but is not limited to this example. In another preferred embodiment, the shape of the battery cell 10 may be other shapes such as a rectangular shape.

For example, in the preferred embodiment described above, the battery cells 10 are connected in series, but the present disclosure is not limited to this example. In another preferred embodiment, the battery cells 10 may be connected in parallel. The same holds for the battery cells 10A.

For example, in the preferred embodiment described above, the battery cells 10 with the same configuration are connected to each other, but the present disclosure is not limited to this example. In another preferred embodiment, battery cells 10 with different configurations may be connected to each other. The same holds for the battery cells 10A.

For example, in the preferred embodiment described above, the number of battery cells 10 to be connected is two, but the present disclosure is not limited to this example. In another preferred embodiment, the number of battery cells 10 to be connected may be one, or three or more. The same holds for the battery cells 10A.

For example, in the preferred embodiment described above, the thermistor is used as the temperature sensor 60, but the present disclosure is not limited to this example. In another preferred embodiment, the temperature sensor 60 may be a thermal resistor. Examples of the thermal resistor include a platinum thermal resistor, a nickel thermal resistor, and a copper thermal resistor. As the thermal resistor, a commercially available thermal resistor can be used without any particular limitation.

For example, in the preferred embodiment described above, a short circuit between the battery cell 10 (or battery cell 10A) and the temperature sensor 60 is detected by comparing the value of the ratio (Vr1/Vr2) with the value of the ratio (R1/R2), but the present disclosure is not limited to this method.

## Claims

1. A battery system (100) comprising:
a battery cell (10);
a temperature sensor (60) that is attached to the battery cell (10) via an insulating member (62) and measures a temperature of the battery cell (10);
a reference power supply (80) that applies a reference voltage (Vref) to the temperature sensor (60);
a first detection resistor (111) located between the reference power supply (80) and the temperature sensor (60);
a second detection resistor (112) located between ground of the battery cell (10) and the temperature sensor (60); and
a short circuit detector (120), wherein
the short circuit detector (120) performs
a first voltage acquisition process of acquiring a voltage applied across the first detection resistor (111),
a second voltage acquisition process of acquiring a voltage applied across the second detection resistor (112), and
a short circuit detection process of detecting a short circuit between the battery cell (10) and the temperature sensor (60) based on a resistance value of the first detection resistor (111), a resistance value of the second detection resistor (112), a voltage value acquired by the first voltage acquisition process, and a voltage value acquired by the second voltage acquisition process.

2. The battery system (100) according to claim 1, wherein
the short circuit detector (120) also performs
a calculation process of calculating a ratio of Vr1 to Vr2 (Vr1/Vr2) where Vr1 is a voltage value acquired by the first voltage acquisition process and Vr2 is a voltage value acquired by the second voltage acquisition process, and
a storage process of storing a ratio of R1 to R2 (R1/R2) where R1 is a resistance value of the first detection resistor (111) and R2 is a resistance value of the second detection resistor (112), and
in the short circuit detection process,
detects that no short circuit has occurred between the battery cell (10) and the temperature sensor (60) if a value of the ratio (Vr1/Vr2) is equal to a value of the ratio (R1/R2), and
detects that a short circuit has occurred between the battery cell (10) and the temperature sensor (60) if the value of the ratio (Vr1/Vr2) is different from the value of the ratio (R1/R2) .

3. The battery system (100) according to claim 1 or 2, wherein
the battery cell (10) includes
an electrode body (30) including a positive electrode (31) and a negative electrode (32),
a battery case (20) housing the electrode body (30) and electrically connected to one of the positive electrode (31) and the negative electrode (32), and
an electrode terminal (12) insulated from the battery case (20) and electrically connected to another of the positive electrode (31) and the negative electrode (32).
